# EUROPÄISCHE PATENTANMELDUNG

(11) **EP 1 005 158 A2**
(43) Veröffentlichungstag der Anmeldung: **31.05.2000**
(21) Anmeldenummer: 99123000.4
(22) Anmeldetag: 19.11.1999
(51) Int. Cl.: H03K 17/082

(54) **Schutzschaltung für eine getaktete Halbleiter-Endstufe**

(30) Priorität: 27.11.1998 DE 19854821
(71) Anmelder: ROBERT BOSCH GMBH, 70442 Stuttgart (DE)
(72) Erfinder: Grimm, Andreas, 76316 Malsch (DE)

(57) **Zusammenfassung**

Die Erfindung betrifft eine Schutzschaltung für eine getaktete Halbleiter-Endstufe. Ein eindeutiger Überlastungsschutz wird ohne zusätzliche Kühlung des Halbleiters dadurch erreicht, dass dem Halbleiter (T1) der Halbleiter-Endstufe (T1-V) ein zusätzlicher Überwachungs-Halbleiter (T2) mit integriertem Überlastschutz und Überlast-Diagnoseausgang (dp) parallelgeschaltet ist, dass der Überwachungs-Halbleiter (T2) über die beim Schalten des Halbleiters (T1) der Halbleiter-Endstufe (T1-V) am Verbraucher (V) auftretenden Schaltspitzen ansteuerbar ist und dass über den Überlast-Diagnoseausgang (dp) ein Mikrokontroller (µC) ansteuerbar ist, der in vorgegebener Weise die Ansteuerung des Halbleiters (T1) der Halbleiter-Endstufe (T1-V) verändert.

## Beschreibung

### Stand der Technik

Die Erfindung betrifft eine Schutzschaltung für eine getaktete Halbleiter-Endstufe.

Bei der Anlegung einer getakteten Halbleiter-Endstufe müssen alle Betriebszustände berücksichtigt werden. Gegenüber einem reinen Schaltbetrieb tritt dabei eine erhöhte Verlustleistung am Halbleiter auf. Daher wird in der Regel eine Kühlung des Halbleiters erforderlich, die durch konstruktive Maßnahmen oder durch den Einsatz eines Kühlkörpers erfolgen kann.

Gerade bei sicherheitskritischen Systemen wird aber von dem reinen Schaltbetrieb abgegangen und der getaktete Betrieb vorgenommen.

Es ist Aufgabe der Erfindung, eine Schutzschaltung für eine getaktete Halbleiter-Endstufe zu schaffen, die eine erhöhte Verlustleistung am Halbleiter der Halbleiter-Endstufe verhindert, eine zusätzliche Kühlung des Halbleiters unnötig macht und selbst im Falle des Auftretens einer Überlastung eine Notfunktion der Halbleiter-Endstufe zuläßt.

Diese Aufgabe wird nach der Erfindung dadurch gelöst, dass dem Halbleiter der Halbleiter-Endstufe ein zusätzlicher Überwachungs-Halbleiter mit integriertem Überlastschutz und Überlast-Diagnoseausgang parallelgeschaltet ist, dass der Überwachungs-Halbleiter über die beim Schalten des Halbleiters der Halbleiter-Endstufe am Verbraucher auftretenden Schaltspitzen ansteuerbar ist und dass über den Überlast-Diagnoseausgang ein Mikrokontroller ansteuerbar ist, der in vorgegebener Weise die Ansteuerung des Halbleiters der Halbleiter-Endstufe verändert.

Der zusätzliche Überwachungs-Halbleiter übernimmt als "intelligenter Halbleiter" die Diagnose der Überlastung und der darüber angesteuerte Mikrokontroller greift in den Steuerungsvorgang des Halbleiters der Halbleiter-Endstufe und einem vorgegebenen Problem ein, so dass darüber eine Notfunktion der Endstufe aufrechterhalten werden kann. Dabei können die Schaltspitzen beim Schalten des Verbrauchers über den Steuerkreis des Überwachungs-Halbleiters abgeleitet werden, so dass eine Schutzdiode parallel zum Verbraucher nicht mehr erforderlich ist.

Um größere Leistungen im Taktbetrieb schalten zu können, sieht eine Ausgestaltung vor, dass der Halbleiter der Halbleiter-Endstufe ein N-Kanal-Power-MOS-FET ist, der einen Motor als Verbraucher ein- und ausschaltet.

Eine einfache Überwachung auf Überlastung läßt sich dadurch erreichen, dass der Überwachungs-Halbleiter ein N-Kanal-Power-MOS-FET mit integriertem Temperatursensor ist, der beim Erreichen einer vorgegebenen Temperatur im Halbleiter ein Steuersignal auf dem Überlast-Diagnoseausgang abgibt. Durch das häufige Schatten des Halbleiters wird der N-Kanal-Power-MOS-FET erwärmt und beim Erreichen einer vorgegebenen Temperatur tritt auf dem Überlast-Diagnoseausgang ein Steuersignal auf, das dem Mikrolcontroller zugeführt wird. Der Mikrokontroller übernimmt dann über die Ansteuerung des Halbleiters der Halbleiter-Endstufe die vorgegebene Notfunktion. So kann z.B. beim Einsatz einer getakteten Halbleiter-Endstufe für einen Fensterheber oder für ein Schiebedach selbst bei Überlastungsfeststellung über den Mikrokontroller und den Halbleiter der Halbleiter-Endstufe ein Dauerbetrieb bis zum Erreichen eines vorgegebenen Schaltzustandes herbeigeführt werden.

Der Steuerkreis für den Überwachungs-Halbleiter wird dadurch besonders einfach, dass der Überwachungs-Halbleiter über einen Steuerkreis ansteuerbar ist, der am Verbindungspunkt zwischen dem Halbleiter und dem Verbraucher (V) der Halbleiter-Endstufe angeschaltet ist und eine Diode aufweist, die nur für die am Verbraucher auftretenden Abschaltspitzen durchlässig ist. Dabei kann die Steuerspannung mittels Zenerdioden begrenzt werden.

Spricht der Überlastschutz im Überwachungs-Halbleiter an, dann bestimmt der Mikrokontroller das Geschehen, wenn die Auslegung so vorgenommen ist, dass der Mikrokontroller beim Ansteuern über den Überlast-Diagnoseausgang des Überwachungs-Halbleiters den Halbleiter der Halbleiter-Endstufe unabhängig vom Ansteuersignal für den Taktbetrieb ansteuert. Die Steuerung kann nach einer Ausgestaltung so vorgenommen werden, dass derMikrokontroller den Halbleiter der Halbleiter-Endstufe solange dauernd ansteuert, bis eine vorgegebene Zeit abgelaufen ist oder über ein auftretendes Betriebssignal ein definierter Schaltzustand erreicht ist.

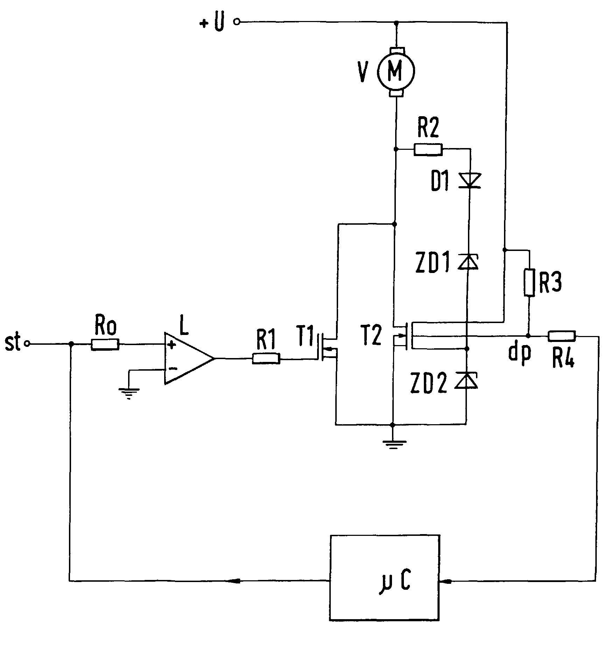

Die Erfindung wird anhand eines in der Zeichnung als Stromlaufplan wiedergegeben Ausführungsbeispiels näher erläutert.

Die Halbleiter-Endstufe umfaßt die Reihenschaltung aus N-Kanal-Power-MOS-FET als Halbleiter T1 und einen Motor M als Verbraucher V. Der Motor M ist am Pluspol + der Versorgungsspannung angeschalten, während der Source-Anschluß des Halbleiters T1 am Massepotential angeschlossen ist.

Das Steuersignal st für den Taktbetrieb der Halbleiter-Endstufe wird über den Widerstand Ro und die Logikschaltung L sowie den Widerstand R1 dem Gateanschluß des Halbleiters zugeführt. Dem Halbleiter T1 ist ein Überwachungs-Halbleiter T2 als "intelligenter Halbleiter" parallelgeschaltet, der ebenfalls als N-Kanal-Power-MOS-FET ausgebildet ist und als Überlastsensor einen Temperatursensor integriert hat. Dieser Temperatursensor spricht bei einer vorgegebenen Temperatur im Halbleiter T2 an und gibt auf einem Überlast-Diagnoseausgang dp ein Ausgangssignal ab, das das Erreichen des kritischen Zustandes anzeigt.

Der Überwachungs-Halbleiter T2 wird über einen Steuerkreis angesteuert, der am Verbindungspunkt zwischen dem Halbleiter T1 und dem Verbraucher V abzweigt. Die Ankopplung erfolgt über einen Widerstand R2 und eine Diode D1, die nur für die positiven Abschaltespitzen am Verbraucher V durchlässig ist. Daher wird der Überwachungs-Halbleiter T2 nur jeweils am Ende der Taktimpulse angesteuert und nimmt die Leistung der Abschaltimpulse auf. Erwärmt sich der Überwachungs-Halbleiter T2 dabei soweit, dass der Temperatursensor anspricht, dann erhält der Mikrokontroller µC über den Widerstand R4 ein Ausgangssignal vom Überlast-Diagnoseausgang dp, das auch von dem am Pluspotential + der Versorgungsspannung U angeschalteten Widerstand R3 abhängig ist. Die Ansteuerung des Halbleiters T2 wird durch die in Reihe geschalteten Zenerdioden ZD1 und ZD2 begrenzt.

Der Mikrokontroller µC steuert über den Widerstand Ro und die Logikschaltung L jetzt den Halbleiter T1 der Halbleiter-Endstufe in eigener Weise an. So kann der Taktbetrieb in einen Dauerbetrieb verändert werden, der z.B. nur eine bestimmte Zeit aufrechterhalten wird oder bis über ein anderes Betriebssignal ein definierter Schaltzustand angezeigt wird. Dieses Betriebssignal kann dem Mikrocontroller µC zugeführt werden und z.B. bei einem Fensterheber oder bei einem Schiebedach einen definierten Endzustand anzeigen, mit dem dann auch eine endgültige Abschaltung der Ansteuerung der Halbleiter-Endstufe verbunden sein kann.

## Patentansprüche

1. Schutzschaltung für eine getaktete Halbleiter-Endstufe,
dadurch gekennzeichnet,
dass dem Halbleiter (T1) der Halbleiter-Endstufe (T1-V) ein zusätzlicher Überwachungs-Halbleiter (T2) mit integriertem Überlastschutz und Überlast-Diagnoseausgang (dp) parallelgeschaltet ist,
dass der Überwachungs-Halbleiter (T2) über die beim Schalten des Halbleiters (T1) der Halbleiter-Endstufe (T1-V) am Verbraucher (V) auftretenden Schaltspitzen ansteuerbar ist und
dass über den Überlast-Diagnoseausgang (dp) ein Mikrokontroller (µC) ansteuerbar ist, der in vorgegebener Weise die Ansteuerung des Halbleiters (T1) der Halbleiter-Endstufe (T1-V) verändert.

2. Schutzschaltung nach Anspruch 1,
dadurch gekennzeichnet,
dass der Halbleiter (T1) der Halbleiter-Endstufe (T1-V) ein N-Kanal-Power-MOS-FET ist, der einen Motor (M) als Verbraucher (V) ein- und ausschaltet.

3. Schutzschaltung nach Anspruch 1 oder 2,
dadurch gekennzeichnet,
dass der Überwachungs-Halbleiter (T2) ein N-Kanal-Power-MOS-FET mit integriertem Temperatursensor ist, der beim Erreichen einer vorgegebenen Temperatur im Halbleiter (T2) ein Steuersignal auf dem Überlast-Diagnoseausgang (dp) abgibt.

4. Schutzschaltung nach einem der Ansprüche 1 bis 3,
dadurch gekennzeichnet,
dass der Überwachungs-Halbleiter (T2) über einen Steuerkreis ansteuerbar ist, der am Verbindungspunkt zwischen dem Halbleiter (T1) und dem Verbraucher (V) der Halbleiter-Endstufe (T1-V) angeschaltet ist und eine Diode (D1) aufweist, die nur für die am Verbraucher (V) auftretenden Abschaltspitzen durchlässig ist.

5. Schutzschaltung nach einem der Ansprüche 1 bis 4,
dadurch gekennzeichnet,
dass die Steuerspannung für den Überwachungs-Halbleiter (T2) mittels Zenerdioden (ZD1, ZD2) begrenzt ist.

6. Schutzschaltung nach einem der Ansprüche 1 bis 5,
dadurch gekennzeichnet,
dass der Mikrokontroller (µC) beim Ansteuern über den Überlast-Diagnoseausgang (dp) des Überwachungs-Halbleiters (T2) den Halbleiter (T1) der Halbleiter-Endstufe (T1-V) unabhängig vom Ansteuersignal (st) für den Taktbetrieb ansteuert.

7. Schutzschaltung nach Anspruch 6,
dadurch gekennzeichnet,
dass der Mikrokontroller (µC) den Halbleiter (T1) der Halbleiter-Endstufe (T1-V) solange dauernd ansteuert, bis eine vorgegebene Zeit abgelaufen ist oder über ein auftretendes Betriebssignal ein definierter Schaltzustand erreicht ist.
